# EUROPEAN PATENT SPECIFICATION

(11) **EP 4 155 619 B1**
(45) Date of publication and mention of the grant of the patent: **30.10.2024**
(21) Application number: 22197122.9
(22) Date of filing: 22.09.2022
(51) Int. Cl.: F24H 3/02, F24H 9/00, F24H 15/407, F24H 3/04, F24H 9/20, A47K 10/48, E03D 9/04, A47K 13/30

(54) **HEATER FOR WARM AIR**
WARMLUFTERHITZER
DISPOSITIF DE CHAUFFAGE D'AIR

(30) Priority: 24.09.2021 CN 202122324680 U
(43) Date of publication of application: 29.03.2023
(73) Proprietor: Shanghai Kohler Electronics, Ltd., Shanghai 200444 (CN)
(72) Inventor: XU, Houyong, Shanghai (CN); SHE, Yan, Shanghai (CN)
(74) Representative: Barker Brettell LLP

(56) References cited:
- EP-A1- 3 096 587
- WO-A1-03/086018
- DE-A1- 102011 005 733
- FR-A1- 2 855 933

## Description

### Technical Field

This disclosure belongs to the technical field of intelligent toilets, and particularly relates to a driving part of a warm air heater and the warm air heater.

### Background

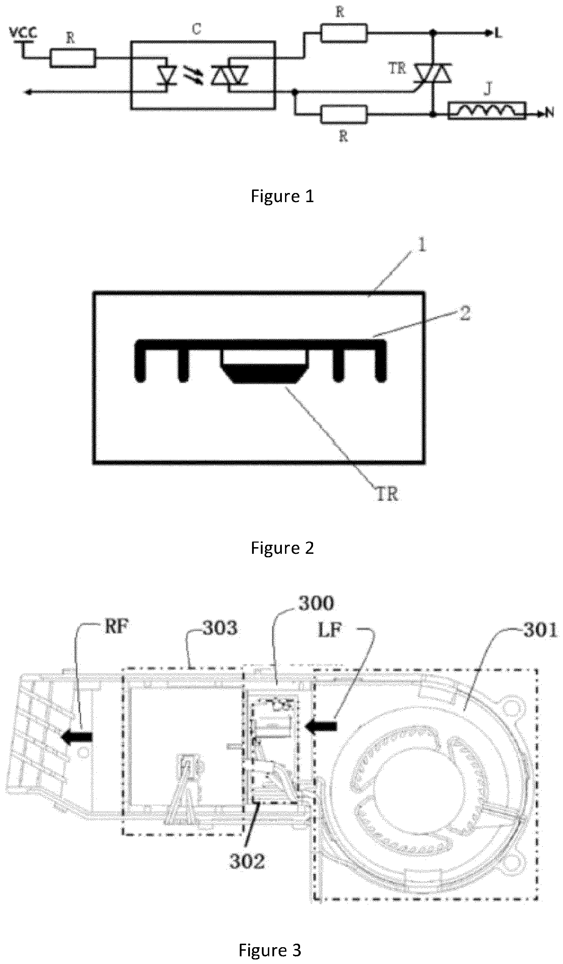

At present intelligent toilet bowl is most configured with the warm air heater, and the drive circuit of warm air heater is as shown in fig. 1, and drive circuit sets up on intelligent toilet bowl's main control circuit board under general condition, and heater block J sets up near the export in warm air heater wind channel, and drive circuit can drive the electric current change in the heater block J and change the temperature of heater block J, and cold wind is blown out from the export in wind channel after being heated by the heater block.

As shown in the figures, the drive circuit comprises a thyristor TR, and the power of the warm air heater is higher, typically 150-300W, which requires that the drive circuit itself also has higher power, and the too high power may cause the temperature of the thyristor in the drive circuit to be too high and cause the problems of thermal breakdown failure of the thyristor, and the like. In order to avoid the problem that the temperature of the thyristor is too high, as shown in fig. 2, a large-area heat sink 2 is disposed on a PCB 1 on which the thyristor is disposed, so as to improve the heat dissipation efficiency and solve the problem of heat dissipation of the thyristor. However, the driving circuit is disposed on the main control circuit board (i.e., the PCB board 1 needs to be disposed on the main control circuit board), the space of the installation position of the main control circuit board is limited, it is difficult to dispose a large-area heat sink, and even if the heat dissipation of the thyristor is improved by disposing the large-area heat sink, the dissipated heat is also collected in the installation space of the main control circuit board, which leads to the overall increase of the internal temperature of the space, and may adversely affect the working performance of the main control circuit board.

EP3096587 discloses an electrical heating device, in particular for a motor vehicle, with at least one heating element and with at least one control device with a housing, with at least one printed circuit board, with a first printed circuit board section and a second printed circuit board section, and with at least one first plug-in device and with at least one second plug-in device, the two plug-in devices for connecting the at least one heating element to the control device, the housing only partially accommodating the at least one printed circuit board, the first printed circuit board section being arranged in the housing and the second printed circuit board section emerging from the housing s and the at least one first plug-in device is connected to the second printed circuit board section and the at least one second plug-in device is connected to the heating element.

WO 03/086018 A1 discloses an electric heating device comprising an electric radiator heating the air which penetrates said radiator. The radiator is provided with a housing, at least one resistive element that is mounted in the housing and is formed by at least one zigzag-shaped metal ribbon which is disposed such that said metal ribbon is directly exposed to the air penetrating the housing, and a circuit controlling the electric power supplied to the resistive element(s) which is/are connected to a source of power. The electric radiator comprises a set of individual heating modules which are disposed parallel to each other inside the housing and in such a way that said heating modules are directly exposed to the air penetrating the housing. Each heating module is provided with a folded or undular metal ribbon and an electronic interrupter which is controlled by the control circuit selectively blocking the supply of electric power to the metal ribbon.

FR 2855933 A1 discloses a device that has a case circulated with air to be heated and delimiting a heat space that comprises of electrical heating modules. Each heating module has two metallic ribbons and resistive units with positive temperature coefficient. The case has supply compartments for housing supply modules. The supply compartments constitute an active zone in the delimited heat space.

DE102011005733 discloses heat-dissipating fins are provided on a top surface of a case in which a plurality of electronic control circuits for controlling a plurality of on-vehicle components are housed. The heat-dissipating fins extend into an air passage formed by an air-intake-side duct of an air conditioner on an upstream side of a blower device. Heat generating elements of the plurality of electronic control circuits are fixed to a heat dissipating surface which is an inner surface of the case adjacent to the top surface on which the heat dissipating fins are provided.

### SUMMARY

The disclosure aims to solve the technical problem that a thyristor in a driving circuit of the existing warm air heater has poor heat dissipation effect and provides a driving part of the warm air heater and the warm air heater.

According to an aspect of the disclosure there is provided a heater for warm air as defined in the appended claims.

Compared with the prior art, the technical scheme provided by the utility model at least has the following beneficial effects: the drive circuit board with driver part sets up in the wind channel alone, is located the upper reaches of heater block or with heater block looks parallel and level, therefore the cold wind that the fan blew out can directly cool down the silicon controlled rectifier element in the drive circuit board. The driving part of the utility model utilizes the fan to cool the silicon-controlled element, can realize good cooling effect without increasing large-area radiating fins, and reduces the cost of the driving part.

### Drawings

FIG. 1 is a schematic circuit diagram of a heater driving unit;
FIG. 2 is a schematic diagram of a prior art arrangement of a large area heat sink for a silicon controlled device;
FIG. 3 is a schematic diagram illustrating a position relationship of a driving part of the heater in an air duct according to an embodiment of the present invention;
FIG. 4 is a schematic view of the airflow direction within the air chute of the embodiment of FIG. 3;
FIG. 5 is a schematic diagram illustrating a position relationship of a driving part of a heater according to another embodiment which is not part of the present invention;
FIG. 6 is a schematic view of the airflow direction within the air chute of the embodiment of FIG. 5;
FIG. 7 is a schematic structural view of a wind tunnel splice according to an embodiment of the present invention.

### Detailed Description

The embodiments of the present invention will be further described with reference to the accompanying drawings. In the description of the present invention, it should be noted that the terms "center", "upper", "lower", "left", "right", "vertical", "horizontal", "inner", "outer", etc., indicate orientations or positional relationships based on the orientations or positional relationships shown in the drawings, and are only for convenience of description of the present invention, and do not indicate or imply that the device or assembly referred to must have a specific orientation, be constructed and operated in a specific orientation, and thus, should not be construed as limiting the present invention. Furthermore, the terms "first," "second," and "third" are used for descriptive purposes only and are not to be construed as indicating or implying relative importance. Wherein the terms "first position" and "second position" are two different positions.

The present invention provides a heater according to claim 1 and shown in fig. 3 to 4. The circuit principle of the driving part can refer to fig. 1, wherein the heating part J is disposed near the outlet of the air duct 300, and the electric connection between the driving circuit board and the heating part J is unchanged. As shown in fig. 3 to 6, a first mounting position 302 for disposing a driving circuit board disposed at the first mounting position 302 in the wind tunnel 300 of the warm air heater and a second mounting position 303 for disposing a heating member J may be included in the wind tunnel 300. The driving circuit board is located at the upstream of the heating component J or is flush with the heating component J, wherein the upstream or flush is based on the airflow direction in the air duct 300.

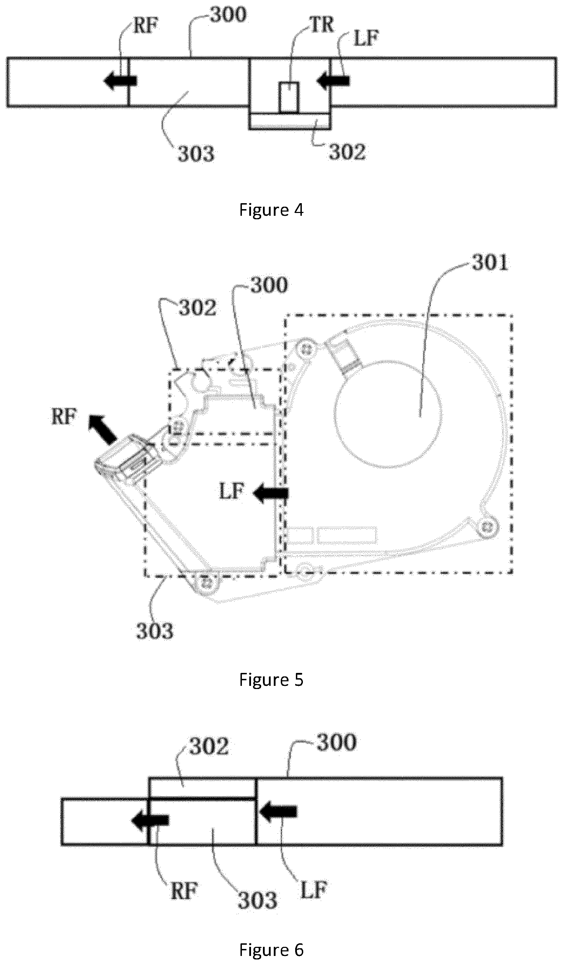

In the above scheme, the relationship between the fan 301, the first mounting position 302 and the second mounting position 303 can be determined by combining fig. 4 and fig. 6. In fig. 3 and 4, fan 301 blows out cold wind LF back, and cold wind LF passes through first mounted position 302 earlier and passes through second mounted position 303 again, becomes hot-blast RF after being heated by heating member J, so thyristor TR of first mounted position 302 department can dispel the heat under the effect of cold wind LF, and has splendid radiating effect, and the heat that thyristor TR effuses can be blown out along wind channel 300 in addition, cannot be detained in thyristor TR's mounted position. In fig. 5 and 6, which are not part of the current invention, after the fan 301 blows out the cold wind LF, the cold wind LF simultaneously passes through the first mounting position 302 and the second mounting position 303, and is heated by the heating part J when passing through the second mounting position 303 and becomes hot wind RF, so the thyristor TR at the first mounting position 302 still is acted on by the cold wind LF, can dispel the heat under the effect of the cold wind LF, and the heat that the thyristor TR dispels can be blown out along the wind channel 300, cannot be detained in the mounting position of thyristor TR.

In the above scheme provided by this embodiment, the driving circuit board including the thyristor is disposed in the air duct 300, and the driving circuit board is disposed at the upstream of the heating component or flush with the heating component, so that the cold air blown by the fan 301 can directly cool the thyristor. The drive unit in this scheme utilizes fan 301's cold wind to cool down the thyristor, need not to increase the large tracts of land fin and also can realize very good cooling effect, has reduced drive unit's cost, in addition, because drive circuit board need not to set up on main control circuit board, also does benefit to main control circuit board installation space's utilization more, can realize the miniaturization of main control part.

It is to be understood that the structure of the warm air heater shown in the above drawings is a schematic view from an external perspective, the driving circuit board described in the embodiments of the present invention is disposed inside the air duct 300, the structure of the air duct 300 itself is well known to those skilled in the art, and the driving circuit board only needs to be disposed at an appropriate position at an upstream or flush position of the heating component J, and is not described in detail in the drawings of the present invention.

In some embodiments, when the driving circuit board is disposed on the inner wall of the air duct 300, the thyristor is disposed in the middle of the air duct 300, that is, in the air flow channel. Because the area of the silicon-controlled element is very small, the silicon-controlled element does not have great influence on the wind speed even if the silicon-controlled element is arranged in the airflow passage, and the silicon-controlled element can be cooled better in the airflow passage.

In some embodiments, the driving part further includes a fixing member, which may be a screw, for fixing the driving circuit board to the inner wall of the air duct. In other embodiments, the driving part further comprises a sealing adhesive layer, the sealing adhesive layer is arranged on the surface of the driving circuit board and between the driving circuit board and the inner wall of the air channel, the driving circuit board can be arranged at the existing sinking position in the air channel at the moment, the sealing adhesive layer can be obtained after the sealing adhesive is poured into the sinking position, the sealing adhesive layer can be rubber, ethylene propylene diene monomer rubber and the like, and the sealing adhesive layer can not only realize the fixation of the driving circuit board, but also prevent the driving circuit board from being affected by damp.

Further, in the driving component of the warm air heater in the above aspect, the silicon-controlled element is provided with a heat sink. The area of the heat sink does not need to be too large, and only needs to be matched with the surface area of the thyristor. The structure of setting up the fin can improve the radiating efficiency of silicon-controlled element, inside wind channel 300 moreover, has the space bigger than main control circuit board mounted position, cannot bring any inconvenience for setting up the fin.

Some embodiments of the present invention further provide a warm air heater, which includes a fan 301, an air duct 300, a heating component and the driving component described in any of the above embodiments; the heating component and the driving circuit board in the driving component are both arranged in the air duct 300, and the position of the driving circuit board in the air duct 300 is located at the upstream of the heating component or is flush with the heating component, wherein the upstream or flush is based on the direction of the air flow in the air duct. As described in the foregoing embodiment, when the warm air heater provided by this embodiment heats the cold air blown out of the fan 301, a large amount of cold air in the air duct 300 plays a role in cooling and dissipating the silicon controlled rectifier on the driving circuit board, which is beneficial to fully utilizing the internal space of the air duct 300, and solves the problem that the occupied internal space is too large due to the large-area heat dissipation fins additionally arranged at the installation position of the main control circuit board in the prior art, and this scheme is beneficial to the modular design of the warm air heating control device, and reduces the design cost.

In the above scheme, the heating component includes but is not limited to a heating coil, a heating wire or a ceramic heater, so that the product can adapt to different air duct shapes and structures and has stronger adaptability.

Preferably, in the above warm air heater, an accommodating cavity is formed in the air duct 300 at a position corresponding to the driving circuit board, and the driving circuit board is disposed in the accommodating cavity. That is, the casing of the air duct 300 is designed to be protruded at the position where the driving circuit board is installed, so that the driving circuit board is installed at the sinking portion, and the driving circuit board is conveniently subjected to waterproof and moisture proof glue filling treatment. On this basis, warm braw heater still includes: the sealing adhesive layer is obtained by pouring colloid into the accommodating cavity. The sealant layer has the effects of preventing corrosion and isolating damp gas and is also beneficial to fixing the driving circuit board.

Preferably, in the warm air heater in the above scheme, the air duct 300 is provided with a lead through hole, and the lead through hole is used for a signal line, a power line and other leads to pass through. Since the driving circuit board needs to receive signals transmitted on the main control circuit board, the driving circuit board needs to be connected with the main control circuit board through signal lines, power lines and the like. In order to simplify the line connection, the wire connection may be implemented from the outside of the air duct 300, and the signal line and the strong current line only need to pass through the wire through hole.

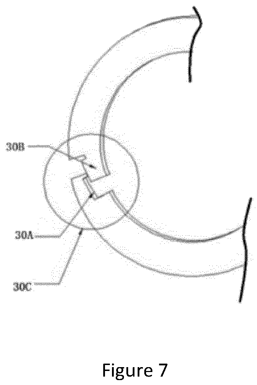

Further preferably, the air duct 300 of the heater, as shown in fig. 7, includes a first assembly 30A and a second assembly 30B, and a locking groove and a tooth are formed at a connection position of the first assembly 30A and the second assembly 30B, respectively, and the tooth is connected to the locking groove in a matching manner. As can be seen from the figure, the joint portion 30C is assembled together by the first assembly 30A and the second assembly 30B in a manner similar to a bayonet fitting, so that the obtained air duct 300 has extremely strong sealing performance, and if water drops exist on the outer wall of the air duct 300, even if the water drops slide to the joint portion 30C, the water drops cannot invade into the air duct 300, so that electronic components inside the air duct 300 can be well protected.

Finally, it should be noted that: the above examples are only intended to illustrate the technical solution of the present invention, but not to limit it; although the present invention has been described in detail with reference to the foregoing embodiments, it will be understood by those of ordinary skill in the art that: the technical solutions described in the foregoing embodiments may still be modified, or some technical features may be equivalently replaced wthin the scope defined by the claims.

## Claims

1. A heater for warm air, comprising:
a fan (301),
an air duct (300),
a heating part disposed in the air duct (300),
a driving part, comprising:
a driving circuit board provided with a silicon-controlled element, the driving circuit board and silicon-controlled element being arranged in the air duct (300) upstream of the heating part relative to the direction of air flow in the air duct (300).

2. The heater of claim 1, wherein:
the driving circuit board is arranged on an inner wall of the air duct (300), the silicon-controlled element being positioned on an airflow passage of the air duct (300).

3. The heater of claim 1 or claim 2, further comprising:
a fixing piece used for fixing the driving circuit board on the inner wall of the air duct (300).

4. The heater of claim 1, claim 2 or claim 3, further comprising:
a sealing adhesive layer arranged on the surface of the driving circuit board and between the driving circuit board and the inner wall of the air duct (300).

5. The heater according to any one of claims 1 to 4, wherein the silicon-controlled element is provided with a heat radiating fin.

6. The warm air heater according to claim 5, wherein the heat radiating fin has a size matched with a surface area of the silicon-controlled element.

7. The heater of any preceding claim , wherein:
the heating part includes a heating coil, a heating wire, or a ceramic heater.

8. The heater of any preceding claim, wherein:
an accommodating cavity is formed in the air duct (300) at a position corresponding to the driving circuit board, and the driving circuit board is arranged in the accommodating cavity.

9. The heater of claim 8, further comprising:
a sealing adhesive layer formed by pouring colloid into the accommodating cavity.

10. The warm air heater according to any preceding claim, wherein:
the air duct (300) includes a first subassembly (30A) and a second subassembly (30B);
the first subassembly (30A) comprises a locking groove and the second subassembly (30B) comprises a tooth; and
the tooth is engaged with the locking groove.

11. The warm air heater according to any preceding claim, wherein:
the air duct (300) comprises at least one through-hole configured to allow a wire to pass through; and
wherein the wire is configured to transmit signals between the driving circuit board and a main control circuit board.

12. The warm air heater according to any preceding claim, wherein:
the driving circuit board is configured to be disposed downstream of the fan (301); and
the fan (301) is configured to flow cold wind to cool down the silicon-controlled element disposed on the driving circuit board.

13. The warm air heater according to any preceding claim, wherein:
the cold wind blown from the fan (301) travels along the air duct (300) to first cool down the silicon-controlled element and then to be heated by the heating part to become warm wind.

## Patentansprüche

1. Erhitzer für Warmluft, umfassend:
einen Lüfter (301),
einen Luftkanal (300),
einen im Luftkanal (300) angeordneten Heizteil,
einen Antriebsteil, umfassend:
eine mit einem siliziumgesteuerten Element bereitgestellte Antriebsleiterplatte, wobei die Antriebsleiterplatte und das siliziumgesteuerte Element im Luftkanal (300) stromaufwärts des Heizteils in Bezug zur Richtung des Luftstroms im Luftkanal (300) eingerichtet sind.

2. Erhitzer nach Anspruch 1, wobei:
die Antriebsleiterplatte an einer Innenwand des Luftkanals (300) eingerichtet ist, wobei das siliziumgesteuerte Element an einem Luftstromdurchgang des Luftkanals (300) positioniert ist.

3. Erhitzer nach Anspruch 1 oder Anspruch 2, weiter umfassend:
ein Befestigungsstück, das zum Befestigen der Antriebsleiterplatte an der Innenwand des Luftkanals (300) verwendet wird.

4. Erhitzer nach Anspruch 1, Anspruch 2 oder Anspruch 3, weiter umfassend:
eine abdichtende Klebeschicht, die auf der Oberfläche der Antriebsleiterplatte und zwischen der Antriebsleiterplatte und der Innenwand des Luftkanals (300) eingerichtet ist.

5. Erhitzer nach einem der Ansprüche 1 bis 4, wobei das siliziumgesteuerte Element mit einer wärmeabstrahlenden Rippe bereitgestellt ist.

6. Warmlufterhitzer nach Anspruch 5, wobei die wärmeabstrahlende Rippe eine Größe aufweist, die mit einem Oberflächenbereich des siliziumgesteuerten Elements übereinstimmt.

7. Erhitzer nach einem vorstehenden Anspruch, wobei:
der Heizteil eine Heizspirale, einen Heizdraht oder einen Keramikerhitzer beinhaltet.

8. Erhitzer nach einem vorstehenden Anspruch, wobei:
ein Aufnahmehohlraum in dem Luftkanal (300) an einer Position gebildet ist, die der Antriebsleiterplatte entspricht, und die Antriebsleiterplatte in dem Aufnahmehohlraum eingerichtet ist.

9. Erhitzer nach Anspruch 8, weiter umfassend:
eine abdichtende Klebeschicht, die durch Gießen von Kolloid in den Aufnahmehohlraum gebildet wird.

10. Warmlufterhitzer nach einem vorstehenden Anspruch, wobei:
der Luftkanal (300) eine erste Unterbaugruppe (30A) und eine zweite Unterbaugruppe (30B) beinhaltet;
die erste Unterbaugruppe (30A) eine Verriegelungsnut umfasst und die zweite Unterbaugruppe (30B) einen Zahn umfasst; und
der Zahn mit der Verriegelungsnut in Eingriff steht.

11. Warmlufterhitzer nach einem vorstehenden Anspruch, wobei:
der Luftkanal (300) mindestens ein Durchgangsloch umfasst, das konfiguriert ist, um es einem Draht zu ermöglichen, hindurchzugehen; und
wobei der Draht konfiguriert ist, um Signale zwischen der Antriebsleiterplatte und einer Hauptsteuerungsplatine zu übertragen.

12. Warmlufterhitzer nach einem vorstehenden Anspruch, wobei:
die Antriebsleiterplatte konfiguriert ist, um stromabwärts des Lüfters (301) angeordnet zu werden; und
der Lüfter (301) konfiguriert ist, um kalten Wind zum Abkühlen des auf der Antriebsleiterplatte angeordneten siliziumgesteuerten Elements auszuströmen.

13. Warmlufterhitzer nach einem vorstehenden Anspruch, wobei:
der vom Lüfter (301) ausgeblasene kalte Wind sich entlang des Luftkanals (300) bewegt, um zuerst das siliziumgesteuerte Element abzukühlen und um dann vom Heizteil erhitzt zu werden, um zu einem warmen Wind zu werden.

## Revendications

1. Dispositif de chauffage à air chaud, comprenant :
un ventilateur (301),
un conduit d'air (300),
une partie chauffante agencée dans le conduit d'air (300),
une partie d'entraînement, comprenant :
une carte de circuit d'attaque munie d'un élément au silicium commandé, la carte de circuit d'attaque et l'élément au silicium commandé étant agencés dans le conduit d'air (300) en amont de la partie chauffante par rapport au sens d'écoulement de l'air dans le conduit d'air (300).

2. Dispositif de chauffage selon la revendication 1, dans lequel :
la carte de circuit d'attaque est agencée sur une paroi intérieure du conduit d'air (300), l'élément au silicium commandé étant positionné sur un passage d'écoulement d'air du conduit d'air (300).

3. Dispositif de chauffage selon la revendication 1 ou la revendication 2, comprenant en outre :
une pièce de fixation utilisée pour fixer la carte de circuit d'attaque sur la paroi intérieure du conduit d'air (300).

4. Dispositif de chauffage selon la revendication 1, la revendication 2 ou la revendication 3, comprenant en outre :
une couche adhésive d'étanchéité agencée sur la surface de la carte de circuit d'attaque et entre la carte de circuit d'attaque et la paroi intérieure du conduit d'air (300).

5. Dispositif de chauffage selon l'une quelconque des revendications 1 à 4, dans lequel l'élément au silicium commandé est muni d'une ailette de refroidissement.

6. Dispositif de chauffage à air chaud selon la revendication 5, dans lequel l'ailette de refroidissement présente une taille adaptée à une surface de l'élément au silicium commandé.

7. Dispositif de chauffage selon une quelconque revendication précédente, dans lequel :
la partie chauffante inclut un serpentin de chauffage, un fil chauffant ou un élément chauffant en céramique.

8. Dispositif de chauffage selon une quelconque revendication précédente, dans lequel :
une cavité de réception est formée dans le conduit d'air (300) à une position correspondant à la carte de circuit d'attaque, et la carte de circuit d'attaque est agencée dans la cavité de réception.

9. Dispositif de chauffage selon la revendication 8, comprenant en outre :
une couche adhésive d'étanchéité formée en versant du colloïde dans la cavité de réception.

10. Dispositif de chauffage à air chaud selon une quelconque revendication précédente, dans lequel :
le conduit d'air (300) inclut un premier sous-ensemble (30A) et un second sous-ensemble (30B) ;
le premier sous-ensemble (30A) comprend une rainure de verrouillage et le second sous-ensemble (30B) comprend une dent ; et
la dent est en prise dans la rainure de verrouillage.

11. Dispositif de chauffage à air chaud selon une quelconque revendication précédente, dans lequel :
le conduit d'air (300) comprend au moins un trou traversant configuré pour permettre le passage d'un fil ; et
dans lequel le fil est configuré pour transmettre des signaux entre la carte de circuit d'attaque et une carte de circuit de commande principale.

12. Dispositif de chauffage à air chaud selon une quelconque revendication précédente, dans lequel :
la carte de circuit d'attaque est configurée pour être disposée en aval du ventilateur (301) ; et
le ventilateur (301) est configuré pour faire circuler du vent froid afin de refroidir l'élément au silicium commandé disposé sur la carte de circuit d'attaque.

13. Dispositif de chauffage à air chaud selon une quelconque revendication précédente, dans lequel :
le vent froid soufflé par le ventilateur (301) se déplace le long du conduit d'air (300) pour d'abord refroidir l'élément au silicium commandé, puis pour être chauffé par la partie chauffante pour devenir du vent chaud.
